Europäisches Patentamt

(19) European Patent Office

Office européen des brevets

(11) Publication number: **0 197 738**
**B1**

(12) **EUROPEAN PATENT SPECIFICATION**

(45) Date of publication of patent specification: **08.08.90**

(21) Application number: **86302357.8**

(22) Date of filing: **27.03.86**

(51) Int. Cl.⁵: **H 01 L 21/265, H 01 L 21/00, H 01 L 29/62**

(54) Method for manufacturing an LDD semiconductor device.

(30) Priority: **29.03.85 JP 65428/85**

(43) Date of publication of application:
**15.10.86 Bulletin 86/42**

(45) Publication of the grant of the patent:
**08.08.90 Bulletin 90/32**

(84) Designated Contracting States:
**DE FR GB**

(56) References cited:
**WO-A-82/03948**
**WO-A-84/04204**
**US-A-3 899 363**

**INTERNATIONAL ELECTRON DEVICES
MEETING, TECHNICAL DIGEST, 5th-7th
December 1983, pages 388-391, IEEE, New York,
US; C.DUVVURY et al.: "Series resistance
modeling for optimum design of LDD
transistors"**
**PATENTS ABSTRACTS OF JAPAN, vol. 9, no. 95
(E-310)1818r, 24th April 1985 & JP-A-59 220 971**

(73) Proprietor: **KABUSHIKI KAISHA TOSHIBA
72, Horikawa-cho Saiwai-ku
Kawasaki-shi Kanagawa-ken 210 (JP)**

(72) Inventor: **Aoki, Riichirou c/o Patent Division
Toshiba Corporation 1-1, Shibaura 1-chome
Minato-ku Tokyo (JP)**
Inventor: **Okumura, Katsuya c/o Patent Division
Toshiba Corporation 1-1, Shibaura 1-chome
Minato-ku Tokyo (JP)**

(74) Representative: **Freed, Arthur Woolf et al
MARKS & CLERK 57-60 Lincoln's Inn Fields
London WC2A 3LS (GB)**

(56) References cited:

**IBM TECHNICAL DISCLOSURE BULLETIN, vol.
23, no. 6, November 1980, pages 2577,2578,
New York, US; S. DASH et al.: "Multiple
threshold voltage process for double
polysilicon/silicide MOSFET devices"**
**JOURNAL OF APPLIED PHYSICS, vol. 52, no. 11,
November 1981, pages 6659-6664, American
Institute of Physics, US; M. WITTMER et al.:
"Oxidation kinetics of TiN thin films"**

## Description

This invention relates to a method for manufacturing a semiconductor device, and in particular relates to a metal oxide silicon (MOS) transistor having a lightly doped drain (LDD) structure.

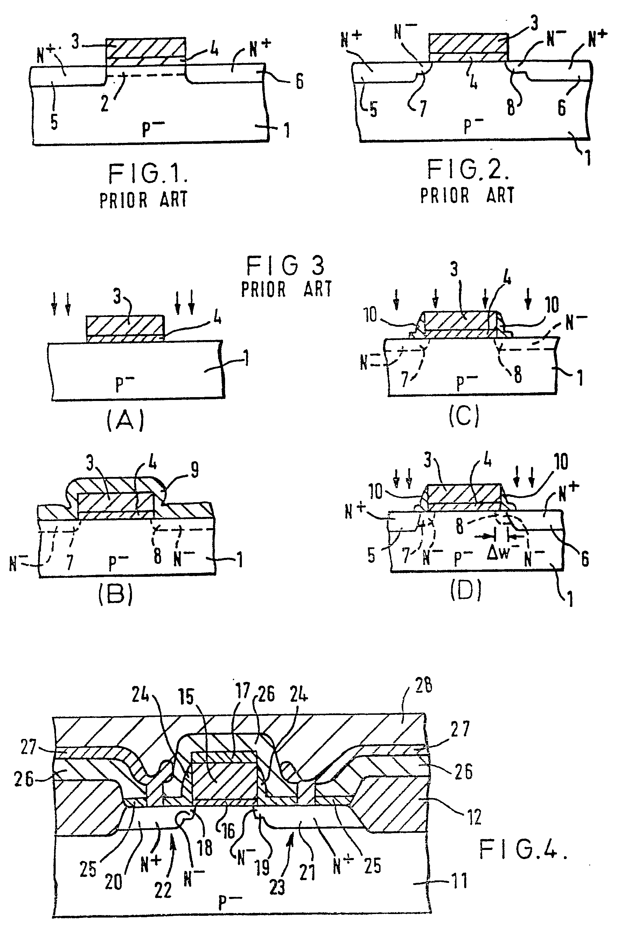

A well-known n channel MOS transistor is shown in Figure 1 and is fabricated as follows. First, a thermal oxide layer 4 is formed on a $p^-$ type silicon substrate 1. Then channel region 2 is provided on silicon substrate 1 by implantation of impurity ions such as boron (B), for controlling the short channel effect of the threshold voltage. After a gate electrode 3 is formed on the thermal oxide layer 4, the thermal oxide layer 4 is selectively removed by an etching technique using the gate electrode 3 as a mask and a gate oxide film 4 is formed. An $n^+$ type source region 5 and a drain region 6 are formed by implantation of impurity ions, for example, arsenic (As), in the silicon substrate 1 using the gate electrode 3 as a mask.

However, when the n channel MOS transistor manufactured by the above-mentioned process is operated, the electric field is concentrated in the vicinity of drain region 6 and a substrate current is increased by generating hole-electron pairs. Electrons inject into the gate insulation layer and as a result the characteristic of the transistor will deteriorate.

The LDD structure MOS transistor has been developed for reducing the above-mentioned problems. As shown in Figure 2, a lightly doped impurity source region 7 and drain region 8 are formed in the vicinity of gate electrode 3. This structure reduces the strength of the high electric field set up in the vicinity of the drain region, because the impurity concentration of source region 7 and drain region 8 is lower than that of source region 5 and drain region 6. As a consequence, electrons are not injected into the gate insulation layer.

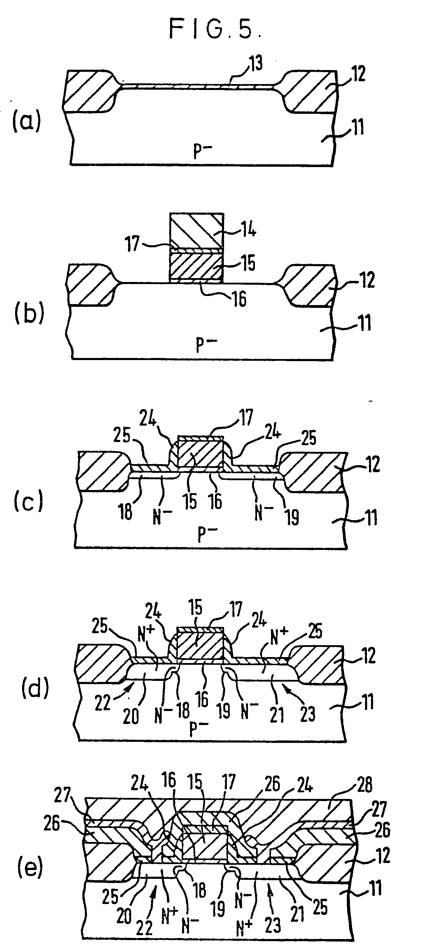

This LDD structure MOS transistor is typically manufactured according to the process shown in Figure 3. First, after a gate oxide layer 4 and a gate electrode 3 are formed on the silicon substrate 1, phosphorus (P) or arsenic (As), for example, is introduced by ion implantation in a light dope using the gate electrode as a mask (see Figure 3A). A source region 7 and a drain region 8 are then activated by heat treatment and an oxide layer 9 of 3000 Angstrom units thickness is deposited using a low temperature (400°C—500°C) and an atmospheric pressure chemical vapor deposition method (APCVD), as shown in Figure 3B.

The oxide layer is anisotropically etched by the reactive ion etching (RIE) method and a side-wall spacer 10 of oxide layer 9 is formed on the lateral face of the gate electrode 3, as shown in Figure 3C.

Next, as shown in Figure 3D, using the gate electrode 4 and the spacer 10 as a mask, arsenic (As) is introduced by ion implantation in a high dope and highly doped source and drain region 5, 6 are formed.

Spacer 10 cannot be accurately formed by the above method because the formation of CVD oxide layer 9 for making spacer 10 is normally carried out under a temperature of 400—500°C at atmospheric pressure which results in the thickness of oxide layer 9 on the lateral face of the gate electrode 3 being thinner than that on the top portion of gate electrode 3 (20—40% thinner). This is referred to as an overhang structure. Since the thickness of the CVD oxide layer 9 is not uniform, the etching amount etched by the reactive ion etching is not uniform, and the width of spacer 10 will vary. With variations in the width of spacer 10, it becomes very difficult to control the width, delta W, of the drain region 8 and the characteristic of the MOS transistor fabricated by this process may vary.

The oxide layer 9 can also be formed using a high temperature (900°C) and low pressure (1.5 torr) CVD (LPCVD) method for overcoming some of the problems inherent in the APCVD method discussed above. The oxide layer formed by the LPCVD method does not have an overhang structure. However, the spacer still cannot be accurately formed by this method because the thickness of the oxide layer on the lateral face of the gate electrode is still thinner than that of the oxide layer on the gate electrode and the etching rate of the oxide layer on the lateral face of the gate electrode is faster than that of the oxide layer on the gate electrode. Furthermore, there is the problem of increasing the diffusion depth in the LPCVD method because of the use of a high temperature. It is difficult to fabricate the oxide layer accurately, and to control the thickness of this oxide layer without causing fluctuations in MOS transistor characteristics.

Document WO—A—8404204 discloses a method of manufacturing a LDD semiconductor device in which an insulating film, a conductive layer and a layer with an oxidation rate lower than that of the conductive layer, are formed on the surface of a substrate. The layer with the lower oxidation rate is formed of $Si_3N_4$. A first impurity diffusion region is formed using the gate as a mask. A first oxide layer is formed on the sides of the gate and a second oxide layer is formed on the surface of the substrate. A second impurity diffusion region is formed, with a higher impurity concentration than said first such region, using the gate and the first oxide layer as a mask. The layer with the lower oxidation rate is removed after formation of the first and second oxide layers.

Document JP—A—59220971 discloses a method of manufacturing a semiconductor device in which the location of relatively high and low impurity regions is controlled using a mask at the sides of the gate.

Attention is also directed to the Journal of Applied Physics, Vol. 52, No. 11, November 1981, pages 6659—6664. This is an article by M. Wittmer et al concerning the oxidation kinetics of Tin thin films, with potential use thereof for gate electrodes in semiconductor devices.

An object of the invention is to provide an LDD MOS transistor with reduced fluctuations in its characteristic.

Another object of the invention is to simplify the process of producing an LDD MOS transistor.

Further, an object of the invention is to accurately control the thickness of the oxidation layer.

Another object of the invention is to provide a transistor with a uniform diffusion depth.

According to the present invention there is provided a method for manufacturing a semiconductor device, comprising the steps of:

forming an insulating film on the surface of a semiconductor substrate of a first conductivity type;

forming a gate electrode provided on said insulating film, by forming a first conductive layer on said insulating film;

forming a second conductive layer on said first conductive layer, said second conductive layer having an oxidation rate substantially lower than that of said first conductive layer;

forming a gate insulating layer and a gate electrode by selectively removing said insulating film, said first conductive layer and said second conductive layer;

forming a first impurity diffusion region of a second conductivity type in said semiconductor substrate, using said gate electrode as a mask;

forming a first oxide layer on the lateral faces of said gate electrode and a second oxide layer on said semiconductor substrate by thermal oxidation using the second conductive layer as an oxidation mask; and

forming a second impurity diffusion region of a second conductivity type, having a higher concentration than that of said first impurity region, using said gate electrode and said first oxide layer as a mask, said diffusion regions constituting the source and drain regions of the device, the source and drain regions being electrically isolated from one another.

A method of manufacturing an LDD semiconductor device according to the invention will now be described, by way of example, with reference to the accompanying drawings, in which:—

Figure 1 is a cross sectional view showing a prior art MOS transistor;

Figure 2 is a cross sectional view showing a prior art MOS transistor having a LDD structure;

Figure 3 is a cross sectional view showing the prior art process of manufacturing a MOS transistor having a LDD structure;

Figure 4 is a cross sectional view showing an embodiment of a semiconductor device made in accordance with the present invention;

Figure 5 is a cross sectional view showing the process for manufacturing a semiconductor device according to an embodiment of the present invention.

An embodiment of a semiconductor device made in accordance with the present invention is shown in Figure 4. Field oxide films 12 are provided on a $p^-$ type silicon substrate 11. Gate oxide layer 16 is formed on silicon substrate 11 and gate electrode 15 is formed on layer 16. In the preferred embodiment, gate electrode 15 is formed of polysilicon or a combination of polysilicon with a layer of a metal silicide. A conductive titanium nitrate layer (TiN) 17, which has an oxidation rate much slower than that of the gate electrode, is formed on the gate electrode 15. Titanium nitride is selected because it is essentially oxidation proof and forms a very stable layer. Thus, when oxide layers are subsequently formed on the semiconductor device, the titanium nitride resists oxidation which in turn makes it possible to accurately control oxidation in other regions. Accordingly, first and second oxide layers, for example, thermal oxide layers 24, 25 are provided on the semiconductor device but are not formed on titanium nitride layer 17. Oxide layer 24 is located on the lateral faces of gate electrode 15 and oxide layer 25 is located on the surface of silicon substrate 11.

First impurity diffusion regions, for example, $n^-$ type low impurity diffusion regions 18, 19 are provided under the thermal oxide layer 24 formed on the lateral face of the gate electrode 15 and in the silicon substrate 11. Second impurity diffusion regions, whose concentration is higher than that of the first impurity regions, for example, $n^+$ type high impurity diffusion regions 20, 21 are provided under the thermal oxide layer 25 and in the silicon substrate 11. In this way, the source region 22 is formed from the low impurity diffusion region 18 and the high impurity diffusion region 20, and the drain region 23 from the low impurity diffusion region 19 and the high impurity diffusion region 21. An insulation layer 26 is provided on the field oxide films 12, the thermal oxide layers 24, 25 and the titanium nitride layer 17. Contact holes are opened and a wiring layer 27 consisting of an aluminum silicon alloy is provided on the insulation layer 26 to connect the source region 22 and the drain region 23 via the contact holes. A passivation layer 28 is formed on the whole upper surface of the substrate.

An embodiment of a method for manufacturing a semiconductor device according to this invention will now be described with reference to Figure 5.

As shown in Figure 5(a), field oxide films 12 of about 1.0 micron thickness and an oxide layer 13 of about 300 angstrom units thickness are first produced on a $p^-$ type silicon substrate 11. Boron (B) is introduced in a silicon substrate 11, for controlling the threshold voltage, by ion implantation in a dose of $2 \times 10^{11}$ ions $cm^{-2}$ by applying an acceleration voltage of 30 KeV.

Next, as shown in Figure 5 (b), a polycristalline silicon layer 15 having a thickness of 4000 angstrom units and 30 ohm/ is deposited on the whole silicon substrate 11. A titanium nitride (TiN) layer 17 of 1000 angstrom units thickness is formed on the whole polycristalline layer 15 by the reactive sputtering method using a combination of nitrogen and argon gasses. The titanium nitride layer 17, the polycristalline layer 15 and the oxide layer 13 are etched by a reactive ion etching method, using a patterned resist layer 14. The titanium nitride layer 17, the gate electrode 15 and the gate oxide layer 16 of 1.5 micron length are thus formed.

As shown in Figure 5(c), after layer 14 is removed phosphorus (P) is introduced by ion implantation in a dose of $1 \times 10^{13}$ ions $cm^{-2}$, by applying an acceleration voltage of 40 KeV, using the gate electrode 15 as a mask. By thermal treatment in a dry oxide atmosphere, first impurity diffusion regions, that is $n^-$ type low impurity diffusion regions 18, 19 are formed in the substrate 11. First and second silicon oxide layers 24, 25 of 500 angstrom units thickness are then formed on the lateral face of the gate electrode 15 and the exposed portion of the silicon substrate 11. The upper face of the gate electrode 15 is not oxidized as it is covered with the titanium nitride layer 17. The overhang problem is therefore eliminated.

As shown in Figure 5(d), arsenic (As) is introduced by ion implantation in a dose of $5 \times 10^{15}$ ions $cm^{-2}$, applying an acceleration voltage of 600 KeV and using the gate electrode 15 and the silicon oxide layer 24 as a mask. Thermal treatment is performed at 900°C in a nitrogen atmosphere. The second impurity diffusion regions, that is $n^+$ type high impurity diffusion regions 20, 21 of 0.2 micron depth and 50 ohm/ are formed. As a result, high impurity diffusion regions 20, 21 are provided at a position adjacent the low impurity diffusion regions 18, 19. In this manner, a LDD structure is produced.

As shown in Figure 5(e), an insulating layer 26 is then deposited on the whole surface, contact holes are formed in this insulating layer 26 and the thermal oxide layer 25 and a wiring layer 27, consisting of aluminum and silicon alloy, are formed. Finally, passivation layer 28 is deposited.

Accordingly, the silicon oxide layer 24 formed on the lateral face of the gate electrode 15 is used as a spacer. The thickness of this spacer can be accurately controlled because silicon oxide layer 24 is a thermal oxide layer. Thermal oxidation is more easily controllable than the low temperature oxidation techniques in the chemical vapor deposition methods used in the prior art. Because the uniformity of this oxide layer thickness is excellent throughout the whole wafer surface, i.e., less than a 5% variation, fluctuations in MOS transistor characteristics have been essentially eliminated. The process for forming the spacer is much simpler than processes for forming spacers revealed in the prior art. Furthermore, the resistivity of titanium nitride is 22—23 micro ohm-cm and the titanium nitride layer 17 of 100 angstrom thickness, which is formed by the usual sputtering method, has a resistivity of 100 micro ohm-cm. Therefore, when the gate electrode 15 is connected to the wiring layer, there is the added advantage that it is not necessary to remove the titanium nitride layer 17.

In the embodiment discussed above, the titanium nitride layer is directly deposited on the polycristalline silicon gate electrode. However, a metal layer consisting of a material selected from the group consisting of titanium (Ti), tungsten (W) and so on or a silicide compound layer consisting of $TiSi_2$, $WSi_2$ and so on can first be formed on the polycristalline silicon layer. In this manner, the resistivity of the gate electrode decreases and it is possible to attain high speed operation.

The titanium nitride layer in the above-mentioned embodiment can be replaced by a tungsten nitride, a tantalum nitride or the like which has a slower oxidation rate than the gate electrode material.

Explanations given in the description of the above embodiments are based on an $n^-$ channel MOS transistor. It is to be understood, however, that the invention is not limited to this embodiment, and may be applied equally to $p^-$ channel MOS transistors and CMOS transistors.

According to the invention, fluctuations in the characteristic of a LDD MOS transistor can be reduced and the drive ability of the circuit applying these transistors can be increased because a spacer of uniform thickness is provided by a much simpler process.

## Claims

1. A method for manufacturing a semiconductor device, comprising the steps of:

forming an insulating film (16) on the surface of a semiconductor substrate (11) of a first conductivity type;

forming a gate electrode (15) on said insulating film, by forming a first conductive layer (15) on said insulating film;

forming a second conductive layer (17) on said first conductive layer, said second conductive layer having an oxidation rate substantially lower than that of said first conductive layer;

forming a gate insulating layer (16) and a gate electrode (15) by selectively removing said insulating film, said first conductive layer and said second conductive layer;

forming a first impurity diffusion region (18, 19) of a second conductivity type in said semiconductor substrate, using said gate electrode (15) as a mask;

forming a first oxide layer (24) on the lateral faces of said gate electrode (15) and a second oxide layer (25) on said semiconductor substrate by thermal oxidation using the second conductive layer as a oxidation mask; and

forming a second impurity diffusion region (20, 21) of a second conductivity type, having a higher concentration than that of said first impurity region, using said gate electrode and said first oxide layer as a mask, said diffusion regions (18, 20; 19, 21) constituting the source and drain regions (22, 23) of the device, the source and drain regions (22, 23) being electrically isolated from one another.

2. A method for manufacturing a semiconductor device according to claim 1, wherein said second conductive layer (17) consists of a titanium nitride.

3. A method for manufacturing a semiconductor device according to claim 1, wherein said second conductive layer (17) consists of a tungsten nitride.

4. A method for manufacturing a semiconductor device according to claim 1, wherein said second conductive layer (17) consists of a tantalum nitride.

5. A method for manufacturing a·semiconductor device according to claim 1 further comprising the step of forming a metal layer between said first conductive layer and second conductive layer (17).

6. A method for manufacturing a semiconductor device according to claim 5 wherein said metal layer comprises a titanium compound.

7. A method for manufacturing a semiconductor device according to claim 5 wherein said metal layer comprises a tungsten compound.

8. A method for manufacturing a semiconductor device according to claim 5 wherein said metal layer comprises a silicide compound.

**Patentansprüche**

1. Verfahren zur Herstellung einer Halbleiter-Vorrichtung, umfassend die Schritte des:

Bildens eines Isolierfilms (16) auf der Oberfläche eines Halbleiter-Substrats (11) eines erstens Leitfähigkeits-Typs,

Bildens einer Gate-Elektrode (15) auf dem Isolierfilm durch Bilden einer ersten leitfähigen Schicht (15) auf dem Isolierfilm;

Bildens einer zweiten leitfähigen Schicht (17) auf der ersten leitfähigen Schicht, wobei die zweite leitfähige Schicht eine Oxidationsrate hat, die wesentlich niedriger als diejenige der ersten leitfähigen Schicht ist;

Bildens einer Gate-Isolierschicht (16) und einer Gate-Elektrode (15) durch selektive Entfernung der Isolierschicht, der ersten leitfähige Schicht und der zweiten leitfähigen Schicht;

Bildens eines ersten Diffusionsbereichs (18, 19) für Verunreinigungen eines zweiten Leitfähigkeits-Typs in dem Halbleiter-Substrat, wobei die Gate-Elektrode (15) als Maske verwendet wird;

Bildens einer ersten Oxid-Schicht (24) auf den seitlichen Flächen der Gate-Elektrode (15) und einer zweiten Oxid-Schicht (25) auf dem Halbleiter-Substrat durch thermische Oxidation unter Verwendung der zweiten leitfähigen Schicht als Oxidations-Maske; und

Bildens eines zweiten Diffusionsbereichs (20, 21) für Verunreinigungen eines zweiten Leitfähigkeits-Typs mit einer höheren Konzentration als derjenigen in dem ersten Bereich der Verunreinigungen, wobei die Gate-Elektrode und die erste Oxid-Schicht als Maske verwendet werden; wobei die Diffusionsbereiche (18, 19: 20, 21) die Source- und Drain-Bereiche (22, 23) der Vorrichtung bilden, wobei die Source- und Drain-Bereiche (22, 23) voneinander isoliert sind.

2. Verfahren zur Herstellung einer Halbleiter-Vorrichtung nach Anspruch 1, worin die zweite leitfähige Schicht (17) aus einem Titannitrid besteht.

3. Verfahren zur Herstellung einer Halbleiter-Vorrichtung nach Anspruch 1, worin die zweite leitfähige Schicht (17) aus einem Wolframnitrid besteht.

4. Verfahren zur Herstellung einer Halbleiter-Vorrichtung nach Anspruch 1, worin die zweite leitfähige Schicht (17) aus einem Tantalnitrid besteht.

5. Verfahren zur Herstellung einer Halbleiter-Vorrichtung nach Anspruch 1, weiterhin umfassend den Schritt der Bildung einer Metallschicht zwischen der ersten leitfähigen Schicht und der zweiten leitfähigen Schicht (17).

6. Verfahren zur Herstellung einer Halbleiter-Vorrichtung nach Anspruch 5, worin die Metallschicht eine Titan-Verbindung umfaßt.

7. Verfahren zur Herstellung einer Halbleiter-Vorrichtung nach Anspruch 5, worin die Metallschicht eine Wolfram-Verbindung umfaßt.

8. Verfahren zur Herstellung einer Halbleiter-Vorrichtung nach Anspruch 5, worin die Metallschicht eine Silicid-Verbindung umfaßt.

**Revendications**

1. Méthode de fabrication d'un dispositif semi-conducteur, comprenant les opérations consistant à:

former un film isolant (16) sur la surface d'un substrat semi-conducteur (11) d'un premier type de conductivité;

former une électrode de grille (15) placée sur ledit film isolant, en formant une première couche conductrice (15) sur ledit film isolant;

former une deuxième couche conductrice (17) sur ladite première couche conductrice, ladite deuxième couche conductrice présentant une vitesse d'oxydation sensiblement inférieure à celle de ladite première couche conductrice;

former une couche isolante de grille (16) et une électrode de grille (16) en éliminant sélectivement ledit film isolant, ladite première couche conductrice et ladite deuxième conductrice;

former une première région de diffusion d'impuretés (18, 19) d'un deuxième type de conductivité dans ledit substrat semi-conducteur, en utilisant ladite électrode de grille (15) comme masque;

former une première couche d'oxyde (24) sur les faces latérales de ladite électrode de grille (15) et une deuxième couche d'oxyde (25) sur ledit substrat semi-conducteur par oxydation thermique en utilisant la deuxième couche conductrice comme masque d'oxydation, et

former une deuxième région de diffusion d'impuretés (20, 21) d'un deuxième type de conductivité, présentant une concentration supérieure à celle de ladite première région d'impuretés, en utilisant ladite électrode de grille et ladite première couche d'oxyde comme masque, lesdites régions de diffusion (18, 20; 19, 21) constituant les régions de source et de drain (22, 23) du dispositif, les régions de source et de drain (22, 23) étant isolées électriquement l'une de l'autre.

2. Méthode de fabrication d'un dispositif semi-conducteur selon la revendication 1, caractérisé en ce que ladite deuxième couche conductrice (17) est constituée d'un nitrure de titane.

3. Méthode de fabrication d'un dispositif semi-conducteur selon la revendication 1, dans laquelle ladite deuxième couche conductrice (17) est constituée de nitrure de tungstène.

4. Méthode de fabrication d'un dispositif semi-conducteur selon la revendication 1, dans laquelle ladite deuxième couche conductrice (17) est constituée de nitrure de tantale.

5. Méthode de fabrication d'un dispositif semi-conducteur selon la revendication 1, comprenant en outre les operations consistant à former une couche métallique entre ladite première couche conductrice et ladite deuxième couche conductrice (17).

6. Méthode de fabrication d'un dispositif semi-conducteur selon la revendication 5, dans laquelle ladite couche métallique comprend un composé de titane.

7. Méthode de fabrication d'un dispositif semi-conducteur selon la revendication 5, dans laquelle ladite couche métallique comprend un composé de tungstène.

8. Méthode de fabrication d'un dispositif semi-conducteur selon la revendication 5, dans laquelle ladite couche métallique comprend un composé de silicide.

FIG.1.
PRIOR ART

FIG.2.
PRIOR ART

FIG 3
PRIOR ART

(A)

(B)

(C)

(D)

FIG.4.

# FIG. 5.

(a)

(b)

(c)

(d)

(e)